# EUROPEAN PATENT APPLICATION

(11) **EP 3 156 622 A1**
(43) Date of publication of application: **19.04.2017**
(21) Application number: 16191233.2
(22) Date of filing: 28.09.2016
(51) Int. Cl.: F01N 5/02

(54) **THERMOELECTRIC GENERATOR TO ENGINE EXHAUST MANIFOLD INTERFACE USING A DIRECT-BOND-COPPER (DBC) ARRANGEMENT**

(30) Priority: 02.10.2015 US 201514873763
(71) Applicant: Delphi Technologies, Inc., Troy, MI 48007 (US)
(72) Inventor: BERLIN, Carl W., Chamberlain, South Dakota 57325 (US); BRANDENBURG, Scott D., Kokomo, Indiana 46902 (US); MYERS, Bruce A., Unionville, Indiana 47468-9728 (US)
(74) Representative: Delphi France SAS

(57) **Abstract**

An assembly (10) for coupling thermally a thermoelectric generator (TEG (12)) to an exhaust manifold includes a first heat-exchanger (14), a first dielectric-layer (24), a TEG (12), and a direct-bond-copper-arrangement (DBC (26)). The first dielectric-layer (24) overlies a portion of the outer surface (22) of the first heat-exchanger (14). The first dielectric-layer (24) is formed by firing a thick-film dielectric material onto the stainless steel of the first heat-exchanger (14). The TEG (12) defines a first contact (30) suitable to be coupled thermally and electrically to the first conductor-layer. The DBC (26) is interposed between the first dielectric-layer (24) and the first contact (30) of the TEG (12). The DBC (26) is formed by an adhesion-layer (50) formed of high-adhesion-copper-thick-film in contact with the first dielectric-layer (24), a bond-layer (52) formed of copper-thick-film that overlies and is in contact with the adhesion-layer (50) opposite the first-dielectric-layer (24), and a copper-foil-layer (54) that overlies and is in contact with the bond-layer (52) opposite the adhesion-layer (50).

## Description

### TECHNICAL FIELD

This disclosure generally relates to equipping a vehicle with a thermoelectric generator (TEG), and more particularly relates to a way of coupling thermally a TEG to an exhaust manifold of an internal combustion engine using a direct-bond-copper-arrangement.

### BACKGROUND OF INVENTION

It has been suggested that up to two-thirds of the fuel consumed to operate an internal combustion engine to propel an automobile is dissipated as waste heat into the atmosphere. It has also been suggested to equip an internal combustion engine with a thermoelectric generator (TEG) to convert some of this waste heat into electricity. TEG's are known devices that generate electricity when coupled thermally to objects that are at different temperatures. In general, the greater the temperature difference between the 'hot' side and the 'cold' side of a TEG, the greater the electrical power that can be produced. It has also been recognized that the greater the thermal conductivity (i.e. less thermal resistance) between an object and a TEG, the greater the electrical power that can be produced. However, because of the temperature extremes in such an application, the materials selected to interface or couple thermally a TEG to an exhaust manifold of an engine must be carefully selected.

### SUMMARY OF THE INVENTION

In accordance with one embodiment, an assembly for coupling thermally a thermoelectric generator (TEG) to an exhaust manifold of an internal combustion engine is provided. The assembly includes a first heat-exchanger, a first dielectric-layer, a TEG, and a direct-bond-copper-arrangement (DBC). The first heat-exchanger is suitable to couple thermally heat from an exhaust gas of an internal combustion engine within the first heat-exchanger to an outer surface of the first heat-exchanger. The outer surface is formed of stainless steel. The first dielectric-layer overlies a portion of the outer surface of the first heat-exchanger. The first dielectric-layer is formed by firing a thick-film dielectric material onto the stainless steel of the first heat-exchanger. The TEG defines a first contact suitable to be coupled thermally and electrically to the first conductor-layer. The DBC is interposed between the first dielectric-layer and the first contact of the TEG. The DBC is formed by an adhesion-layer formed of high-adhesion-copper-thick-film in contact with the first dielectric-layer, a bond-layer formed of copper-thick-film that overlies and is in contact with the adhesion-layer opposite the first-dielectric-layer, and a copper-foil-layer that overlies and is in contact with the bond-layer opposite the adhesion-layer.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is a perspective view of a heat-exchanger assembly in accordance with one embodiment;
Fig. 2 is a sectional side view of the heat-exchanger assembly of Fig. 1 in accordance with one embodiment; and
Fig. 3 is a close-up sectional side view of the heat-exchanger assembly of Fig. 1 in accordance with one embodiment.

### DETAILED DESCRIPTION

Waste heat of the exhaust from internal combustion engines can be converted into energy with the addition of a thermoelectric generator. Automobile exhaust reaches temperatures of about 800°C, and the temperature difference relative to ambient or engine coolant may be used to generate as much or more than one thousand Watts (1000W) of electrical power. This electrical power may, for example, be used to reduce the load on an automobile's alternator, thereby improving fuel economy. Described herein is a way to improve the reliability of a packaging configuration used to couple thermally a thermoelectric device to heat from automobile engine exhaust gas.

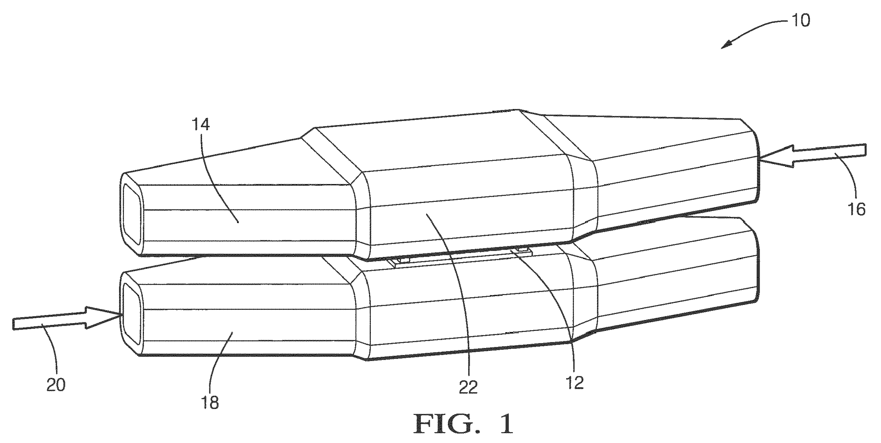

Fig. 1 illustrates a non-limiting example of an assembly 10 that thermally couples thermoelectric material, hereafter the TEG 12, to an exhaust manifold, hereafter the first heat-exchanger 14. Preferably, the first heat-exchanger 14 is part of an exhaust system of an internal combustion engine (not shown) in a vehicle (not shown). Alternatively, the internal combustion engine may be part of a stationary power generation plant that provides mechanical energy and/or electrical energy to a location remote from a typical electrical power grid. As such, for this non-limiting example, the first heat-exchanger 14 is configured to couple thermally the heat of the exhaust gas 16 that is within the first heat-exchanger 14 to the TEG 12.

The TEG 12 generally generates electrical power when a temperature difference is maintained across the TEG 12. By way of example and not limitation, the temperature difference relative to the first heat-exchanger 14 may be provided a second heat-exchanger 18. The second heat-exchanger may be part of a cooling system for an internal combustion engine. As such, for this non-limiting example, the second heat-exchanger 18 is configured to couple thermally to a coolant 20 within the second heat-exchanger 18 to the TEG 12. Alternatively, the second heat-exchanger 18 may be a finned heat sink (not shown) having the fins exposed to ambient air, or coupled to a frame member of the vehicles chassis. Those skilled in the art will recognize that there are many alternatives for providing a 'cold' side to the TEG 12 to establish a temperature difference relative to the 'hot' side coupled to the first heat-exchanger 14. As such, for this alternative embodiment, heat from the exhaust gas may be communicated thermally through the TEG to a heat sink. It is also contemplated that a finned heat sink formed of appropriate material could added to either the first heat-exchanger 14 and/or the second heat-exchanger 18 to further facility heat transfer between the TEG and the exhaust gas 16 or the coolant 20, respectively

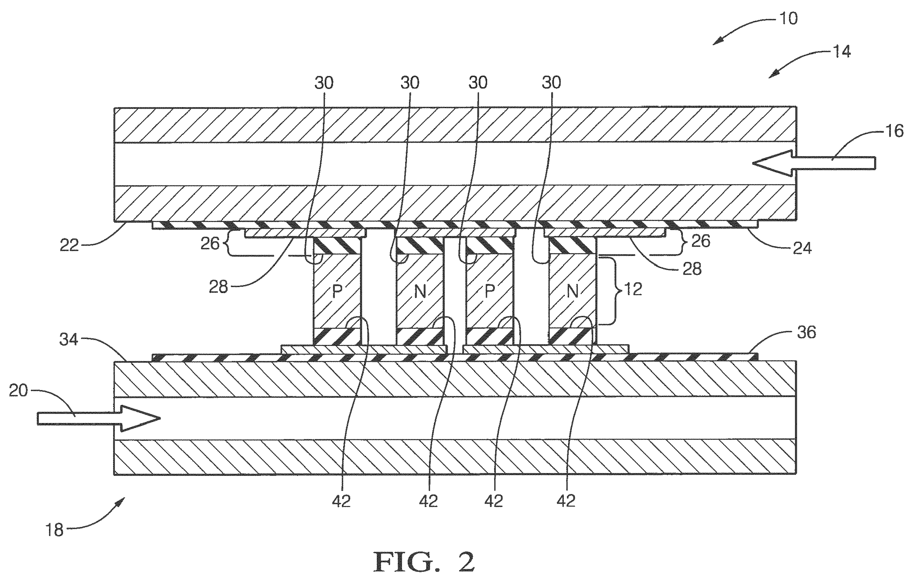

Fig. 2 further illustrates non-limiting details of the assembly 10. The TEG 12 is illustrated as having two p-type and two n-type elements, commonly known as thermoelectric junctions. It should be recognized that a TEG suitable to generate power levels in the kilowatt domain would have many more thermoelectric junctions, and those junction would likely be arranged in a two-dimensional array. The reduced number of junctions shown here and illustrated as a one-dimensional array is only for the purpose of simplifying the illustration.

As described above, the first heat-exchanger 14 is generally configured to couple thermally heat from the exhaust gas 16 of an internal combustion engine (not shown) within the first heat-exchanger 14 to an outer surface 22 of the first heat-exchanger 14. Preferably, the outer surface 22 is formed of stainless steel, such as 400 series stainless-steel, e.g. 430 stainless steel, which is readily from several suppliers. It is contemplated that the entirety of the first heat-exchanger 14 may be formed of stainless steel. That the description above emphasizes the outer surface 22 is only to clarify the explanation given below of other materials that make contact with the outer surface 22.

Using stainless steel for the outer surface 22 is particularly advantageous as it enables applying a first dielectric-layer 24 to overlie a portion of the outer surface 22 of the first heat-exchanger 14. Preferably, the first dielectric-layer 24 is formed by firing a thick-film dielectric material such as DuPont 3500N Thick Film Dielectric onto the stainless steel forming the outer surface 22 of the first heat-exchanger 14.

Prior examples of coupling thermally thermoelectric materials to an exhaust manifold have used an alumina (Al₂O₃) substrate for a dielectric barrier between the thermoelectric generator and a metallic exhaust manifold. Alumina substrates need to be at least seven-hundred-fifty micrometers (750um or 0.75 mm) thick to be strong enough to easily process and use in such an application. Alumina has a thermal conductivity of about thirty Watts per meter-Kelvin (30 W/ (m·°K)) and so a 0.75mm thick alumina substrate can be characterized has having a thermal performance factor of 30/0.75 = 40.

In contrast, thick-film dielectric material such as DuPont 3500N can be applied to have a fired thickness of about thirty-seven micrometers (38um or 0.037mm). DuPont 3500N has a thermal conductivity of about two Watts per meter-Kelvin (2 W/ (m·°K)), and so the first dielectric-layer 24 may be characterized has having a thermal performance factor of 2 / 0.038 = 53, about a 33% improvement in thermal performance when compared to the alumina substrate example above. In other words, using the dielectric-layer for the first dielectric-layer instead of the previously proposed alumina substrate decreases the temperature lost as heat passes from the first heat-exchanger 14 to the TEG 12 by 25%.

Continuing to refer to Fig. 2, the assembly 10 may include a direct-bond-copper-arrangement, hereafter referred to as the DBC 26, overlies the first dielectric-layer 24. In general, the DBC 26 is arranged to interconnect the various elements that make up the assembly 10, and provide a contact pad 28 for making electrical connections (not shown) to the assembly 10. The DBC 26 is generally formed of copper foil and copper thick-film as will be explained in more detail below. Various ways to make electrical connections to the contact pad 28 will be recognized by those skilled in the art. For example, a metallic wire, foil, or ribbon (none shown) may be soldered or brazed to the contact pad 28 so electrical energy generated by the TEG 12 can be conveyed to other locations outside of the assembly.

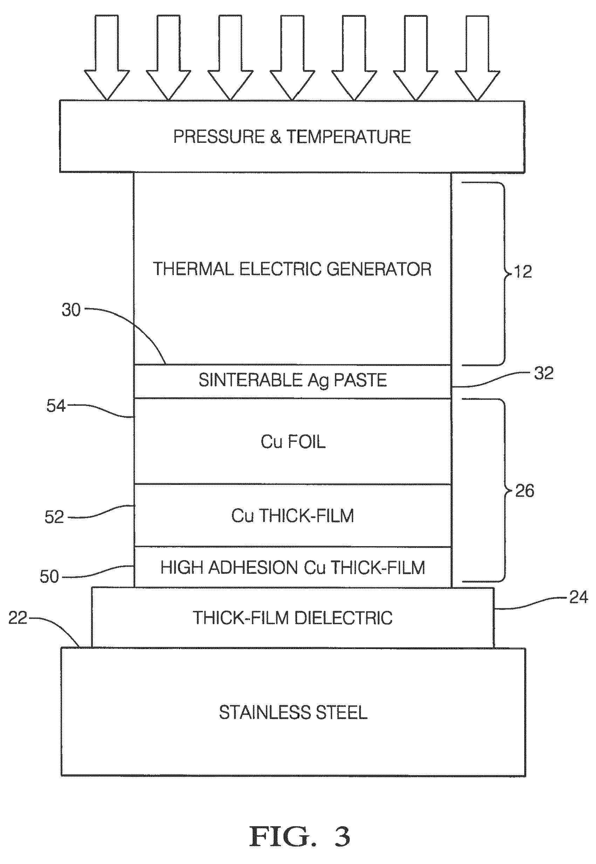

Fig. 3 illustrates further non-limiting details of the assembly 10, in particular, details about the DBC 26. The TEG 12 is generally configured to define a first contact 30 suitable to be coupled electrically to the DBC 26. Electrical and thermal coupling of the first contact 30 to the DBC 26 may be provided by sinterable silver (Ag) paste 32 interposed between the DBC 26 and the first contact 30 of the TEG 12. Accordingly, the first contact 30 and the DCB 26 are suitable for silver sintering. It has been discovered that the bond formed by the sinterable silver (Ag) paste 32 is improved if pressure (i.e. force) is applied to the assembly 10 when the sinterable silver (Ag) paste 32 is fired.

The DBC 26 includes an adhesion-layer 50 formed of a high-adhesion-copper-thick-film in contact with the first dielectric-layer 24. A suitable material for the adhesion-layer 50 is copper thick film #7732 manufactured by DUPONT®, which is preferably printed at a thickness of twenty-five micrometers (25µm) to fifty micrometers (50µm). The adhesion-layer 50 is printed and fired onto the first dielectric-layer 24 prior to adding the other layers of the DCB 26, which are described below.

The DBC 26 includes a bond-layer 52 formed of copper-thick-film that overlies and is in contact with the adhesion-layer 50 opposite the first-dielectric-layer 24, and a copper-foil-layer 54 that overlies and is in contact with the bond-layer 52 opposite the adhesion-layer 50. As suggested above, the adhesion-layer 50 is preferable fired to the first-dielectric-layer 24 prior to printing the bond-layer 52. The copper-foil-layer 54 is preferably applied to the bond-layer 52 while the bond-layer 52 is in a wet-state, i.e. soon after printing of the material that forms the bond-layer 52. A suitable material for the bond-layer 52 is copper thick film QP165 manufactured by DUPONT®, which is preferably printed at a thickness of twenty-five micrometers (25µm) to fifty micrometers (50µm). The copper-foil-layer 54 is preferably formed of pure copper (cleaned and etched) with a suitable thickness of two-hundred-fifty micrometers (250µm).

The copper-foil-layer 54 is bonded to the adhesion-layer 50 by the bond-layer 52 after the layers that form the DPC are dried in a vacuum environment at about 150°C for 1-3 hours, followed by firing for about ten minutes at 900°C in a nitrogen environment, e.g. less than 10ppm oxygen.

The adhesion-layer 50 and/or the bond-layer 52 and/or the copper-foil-layer 54 may be extended beyond the area of the DCB 26 covered by the first contact 30 of the TEG 12 to form the contact pad 28. Which of those layers are extended will be determined by the method selected for making subsequent electrical connections to the assembly 10, as will be recognized by those in the art. It is contemplated that the arrangement of materials that form the DBC 26 may be duplicated to form a connection between a second dielectric layer 36 that overlies a second surface 34 of the second heat-exchanger 18 and a second contact 42 of the TEG 12 that is opposite the first contact 30.

Accordingly, an assembly 10 for coupling thermally a thermoelectric generator (the TEG 12) to an exhaust manifold (e.g. the first heat-exchanger 14) of an internal combustion engine is provided. Testing has shown that such an arrangement can operate reliably above 600C, and will have improved reliability over prior examples of assemblies for coupling thermally a TEG to an exhaust manifold. Furthermore, comparisons to prior examples of coupling thermally a TEG to an exhaust manifold indicate that by using a structurally sound heat exchanger, matched opposing dielectric layers are not required for stress balancing.

While this invention has been described in terms of the preferred embodiments thereof, it is not intended to be so limited, but rather only to the extent set forth in the claims that follow.

## Claims

1. An assembly (10) for coupling thermally a thermoelectric generator (TEG (12)) to an exhaust manifold of an internal combustion engine, said assembly (10) comprising:
a first heat-exchanger (14) suitable to couple thermally heat from an exhaust gas (16) of an internal combustion engine within the first heat-exchanger (14) to an outer surface (22) of the first heat-exchanger (14), wherein the outer surface (22) is formed of stainless steel;
a first dielectric-layer (24) that overlies a portion of the outer surface (22) of the first heat-exchanger (14), said first dielectric-layer (24) formed by firing a thick-film dielectric material onto the stainless steel of the first heat-exchanger (14);
a TEG (12) that defines a first contact (30) suitable to be coupled thermally and electrically to the first conductor-layer; and
a direct-bond-copper-arrangement (DBC (26)) interposed between the first dielectric-layer (24) and the first contact (30) of the TEG (12), wherein the DBC (26) is formed by an adhesion-layer (50) formed of high-adhesion-copper-thick-film in contact with the first dielectric-layer (24), a bond-layer (52) formed of copper-thick-film that overlies and is in contact with the adhesion-layer (50) opposite the first-dielectric-layer (24), and a copper-foil-layer (54) that overlies and is in contact with the bond-layer (52) opposite the adhesion-layer (50).

2. The assembly (10) in accordance with claim 1, wherein the adhesion-layer (50) is printed and fired onto the first dielectric layer prior to printing the bond-layer (52).

3. The assembly (10) in accordance with claim 2, wherein the copper-foil-layer (54) is applied to the bond-layer (52) while the bond-layer (52) is in a wet-state.

4. The assembly (10) in accordance with claim 3, wherein the copper-foil-layer (54) is bonded to the adhesion-layer (50) by the bond-layer (52) after the DBC (26) is dried in a vacuum environment followed by firing in a nitrogen environment.
